# EUROPÄISCHE PATENTSCHRIFT

(11) **EP 1 166 349 B1**
(45) Veröffentlichungstag und Bekanntmachung des Hinweises auf die Patenterteilung: **24.10.2007**
(21) Anmeldenummer: 00926679.2
(22) Anmeldetag: 13.03.2000
(51) Int. Cl.: H01L 21/762, H01L 21/3065

(54) **VERFAHREN ZUR HERSTELLUNG EINER GRABENISOLATION FÜR ELEKTRISCH AKTIVE BAUELEMENTE**
METHOD OF PRODUCING A TRENCH ISOLATION FOR ELECTRICALLY ACTIVE COMPONENTS
PROCEDE POUR REALISER UNE ISOLATION DE TRANCHEES POUR COMPOSANTS A ACTIVITE ELECTRIQUE

(30) Priorität: 11.03.1999 DE 19910886
(43) Veröffentlichungstag der Anmeldung: 02.01.2002
(73) Patentinhaber: Infineon Technologies AG, 81669 München (DE)
(72) Erfinder: UHLIG, Ines, D-01277 Dresden (DE); ZIMMERMANN, Jens, D-01127 Dresden (DE); WEGE, Stephan, D-01474 Weissig (DE)
(74) Vertreter: Ginzel, Christian
(86) Internationale Anmeldenummer: PCT/DE2000/000805
(87) Internationale Veröffentlichungsnummer: WO 2000/054327

(56) Entgegenhaltungen:
- EP-A- 0 200 951
- US-A- 4 729 815
- US-A- 4 855 017
- PATENT ABSTRACTS OF JAPAN vol. 018, no. 020 (E-1489), 13. Januar 1994 (1994-01-13) -& JP 05 259269 A (SHARP CORP), 8. Oktober 1993 (1993-10-08)
- PATENT ABSTRACTS OF JAPAN vol. 011, no. 095 (E-492), 25. März 1987 (1987-03-25) -& JP 61 247032 A (TOSHIBA CORP), 4. November 1986 (1986-11-04)
- WIDMANN D.; MADER M.; FRIEDRICH H.: 'Technologie hochintegrierter Schaltungen', 1996, SPRINGER-VERLAG, BERLIN * Seite 335 - Seite 343 *

## Beschreibung

Die Erfindung liegt auf dem Gebiet der Halbleitertechnologie und betrifft ein Verfahren zur Herstellung einer Grabenisolation.

Grabenisolationen für elektrisch aktive Bauelemente, insbesondere eine flache Grabenisolation (sog. Shallow Trench Isolation) im z.B. kristallinen Silizium, weisen einen mit z.B. einem Oxid gefüllten Graben auf. Im Falle eines dynamischen Halbleiterspeichers (sog. DRAM) ist unter der Grabenisolation ein Kondensatorelement angeordnet, das durch einen Kragen (sog. Collar), bestehend aus einer OxidSchicht, gegenüber dem umgebenden Silizium abgegrenzt ist. Eine derartige Grabenisolation ist beispielsweise aus der US 5,389,559 bekannt.

Bei der Herstellung dieser Grabenisolation werden einzelne Prozeßschritte bei sehr hohen Prozeßtemperaturen durchgeführt, bei denen das Halbleitersubstrat einem erheblichen Wärmestreß insbesondere während der Aufheiz- und der Abkühlphasen ausgesetzt wird. Dabei entstehen mechanische Spannungen im Halbleitersubstrat, die Fehler in der Kristallgitterstruktur zur Folge haben können. An solchen Stellen entstehen Spannungskonzentrationsstellen, die Auslöser für die Bildung von Versetzungen sein können. Derartige Versetzungen können dann zu elektrischen Defekten, z.B. Leckströmen, führen. Diese Leckströme verursachen eine verminderte Ladungserhaltungszeit (Retention Time), so daß die aktiven Bauelemente (Transistor, Kondensatorelement) in ihrer Funktion eingeschränkt sind.

Aus der JS 5,807,789 ist ein Verfahren der eingangs genannten Art bekannt, mit dessen Hilfe eine Grabenisolation geschaffen werden kann, wobei der Graben der Grabenisolation geneigte Seitenwände und runde Ecken aufweist. Bei diesem Verfahren wird die Bildung von Polymeren und deren Ablagerung an den Seitenwänden des sich herausbildenden Grabens genutzt, um die Seitenwände zumindest teilweise gegenüber einem Angriff der verwendeten Ätzgase zu schützen und dadurch ein Ätzprofil mit geneigten Seitenwänden und ggf. verrundeten Ecken zu erreichen. Damit wird versucht, scharfe Kanten am Übergangsbereich zwischen Boden und Seitenwand des Grabens zu vermeiden, da es sich herausgestellt hat, daß derartige scharfe Kanten Ausgangspunkt für die beschriebenen Störungen in der Kristallgitterstruktur sein können.

Ungünstigerweise wird bei dem Verfahren aus der US 5,807,789 ein Gemisch aus chlor-, brom- und fluorhaltigen Gasen verwendet, das sehr aggressiv und schwer beherrschbar ist.

Dadurch läßt sich die Polymerbildung nicht in gewünschter Weise beeinflussen.

In US 4,729,815 ist ein mehrstufiges Ätzverfahren zum Ätzen von tiefen Gräben in Silizium beschrieben. Dabei wird in einem ersten und einem zweiten Ätzschritt NF₃ und CHF₃ zu je gleichen Teilen verwendet. Durch Veränderung der Vorspannung kann die Anisotropie der Ätzung bei ansonsten gleicher Ätzgaszusammensetzung eingestellt werden, wobei im zweiten Ätzschritt die Vorspannung gegenüber dem ersten Ätzschritt erhöht und dadurch der zweite Ätzschritt isotrop im Vergleich zum ersten Ätzschritt ist. In einem dritten Ätzschritt wird lediglich NF₃ zum vollständigen Verrunden von Ecken verwendet.

In US 4,855,017 ist ein Siliziumätzverfahren unter Verwendung von bromhaltigen Ätzgasen beschrieben.

Aus EP 0 200 951 ist ein anisotropes Siliziumätzverfahren in einem fluorierten Hochdruckplasma bekannt. Als Ätzgas wird beispielsweise eine Mischung aus NF₃, N₂ und CHF₃ als polymerbildender Gasbestandteil verwendet.

Der Erfindung liegt deshalb die Aufgabe zugrunde, ein einfaches Verfahren zur Herstellung einer Grabenisolation zu schaffen.

Die der Erfindung zugrundeliegende Aufgabenstellung wird durch das Verfahren gemäß Anspruch 1 gelöst.

Bei einer mit dem erfindungsgemäßen Verfahren hergestellten Grabenisolation wird das Entstehen von Störungen in der Kristallgitterstruktur ebenfalls zuverlässig verhindert. Weiterhin besitzen die geneigten (getaperten) Seitenwände den besonderen Vorteil, daß das nach dem Trockenätzen notwendige Auffüllen des STI mit einem Oxid wesentlich verbessert wird.

Gemäß der Erfindung weist das Ätzgas NF₃, CHF₃ und N₂ mit einem überwiegenden Anteil von CHF₃ und wenig NF₃ auf.

In einer weiteren besonderen Ausgestaltung der Erfindung wird nach der Bildung des Grabens ein weiterer Trockenätzschritt mit einem weiteren Ätzgas durchgeführt, durch den die Ecken am Übergang vom Boden des Grabens zu dessen Seitenwänden verrundet werden, wobei der weitere Trockenätzschritt eine isotrope Ätzkomponente aufweist. Dadurch werden geneigte Seitenwände mit verrundeten Ecken geschaffen. Bevorzugt enthält bei diesem Trockenätzschritt das weitere Ätzgas NF₃, CHF₃, N₂ mit einem überwiegenden Anteil von NF₃.

Vorzugsweise werden Trockenätzschritte durch magnetfeldverstärktes reaktives Ionenätzen mit ICP (Inductive Coupled Plasma Source) bzw. mit ECR (Electrical Cyclotron Resonance) unterstützt.

In einer Variante des erfindungsgemäßen Verfahrens wird zum Trockenätzen eine getaperte Maske verwendet.

Sofern der Graben nur in einem Trockenätzschritt gebildet wird, sollte darauf geachtet werden, daß ein sich eventuell am Boden des Grabens befinden der Oxidkragen eines Kondensatorelements mit der gleichen Geschwindigkeit geätzt wird, wie das übrige Oxid bzw. das umgebende Halbleitersubstrat.

Die Erfindung soll nachfolgend an einem Ausführungsbeispiel näher erläutert werden. In den zugehörigen Zeichnungen zeigen:
- Fig. 1: eine Grabenisolation (Shallow Trench Isolation) mit abgerundeten Kanten am Boden; und

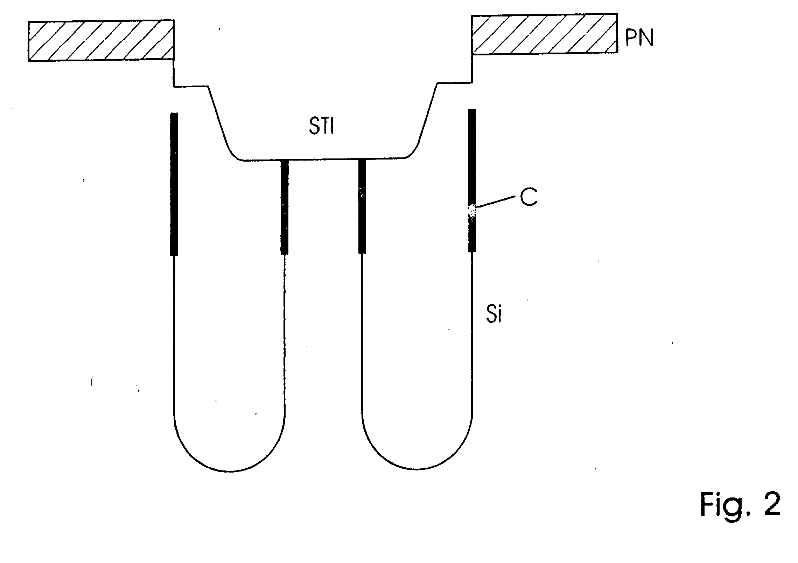

- Fig. 2: eine Grabenisolation mit abgerundeten Kanten am Boden und zusätzlichen abgeschrägten Seitenwänden.

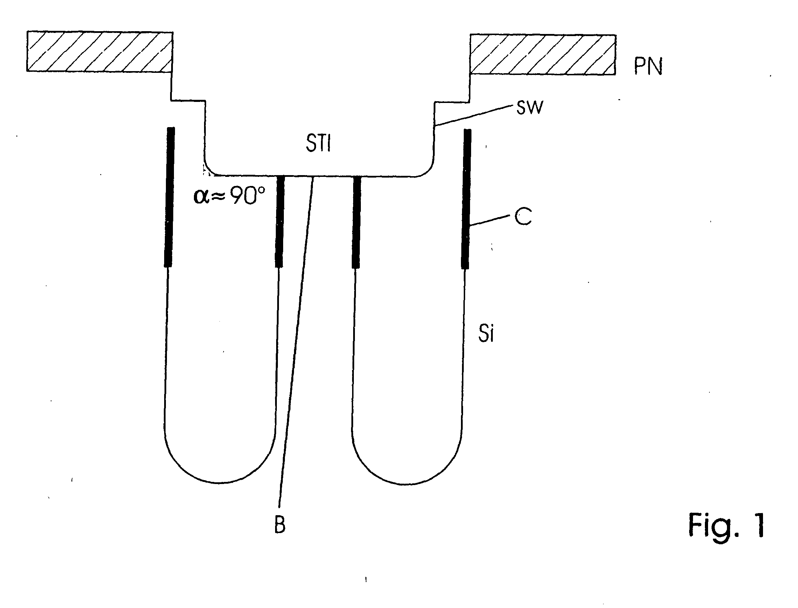

Wie aus den zugehörigen Zeichnungsfiguren ersichtlich ist, ist der Boden B des Grabens für die Grabenisolation STI so gestaltet daß dieser kontinuierlich in die Seitenwände SW übergeht. Vorzugsweise ist der Übergang zwischen dem Boden und den Seitenwänden abgerundet (Fig. 1). Obwohl damit bereits ein weitgehender Abbau von thermisch bedingten Spannungen in der Kristallgitterstruktur des poly- und des kristallinen Siliziums erreicht werden kann ist zusätzlich vorgesehen, den Graben für die Grabenisolation zusätzlich mit getaperten, d.h. abgeschrägten Seitenwänden zu versehen. Der Winkel a zwischen dem Boden und den Seitenwänden SW sollte dabei zwischen 75°< a < 90° liegen. Ein besonderer Vorteil getaperter Seitenwände ist auch in der verbesserten Geometrie zur Auffüllung des Grabens mit einem Oxid zu sehen.

Beide Maßnahmen können sowohl getrennt, als auch kombiniert miteinander angewendet werden.

Die Herstellung einer Grabenisolation wird nachfolgend an einem Beispiel näher erläutert werden. In diesem Beispiel dient die Grabenisolation zur Isolierung zweier benachbarter Trench-Kondensatoren, die in das Si-Substrat, das hier das Halbleitersubstrat bildet, geätzt wurden und nach Bilden eines Kondensatordielektrikums und eines Collars an der unteren bzw. oberen Trench-Wand mit Polysilizium aufgefüllt sind. Die Grabenisolation überlappt die Trench-Kondensatoren teilweise, wie in den Figuren ersichtlich.

Dazu werden in diesem Fall zunächst das Pad Nitride PN (Si₃N₄), ggf. auch andere Reste einer Trench-Ätzmaske, und anschließend das Poly- und kristalline Silizium mit hoher Selektivität zur Lackmaske geätzt. Mit der gleichen Ätzrate muß auch der Collar C geätzt werden. Die Herstellung des STI kann in einem mehrstufigen oder auch einem einstufigen Verfahren erfolgen. Dazu werden zur Trockenätzung der getaperten Seitenwände des STI Ätzgase eingesetzt, wobei zusätzlich ein Trockenätzen durch magnetfeldverstärktes reaktives Ionenätzen vorgesehen werden kann. Zusätzlich kann zum Trockenätzen eine getaperte Maske verwendet werden.

Als besonders geeignet für die Ätzung des Siliziums zur Bildung des Grabens haben sich Ätzgase herausgestellt, die CHF₃ und NF₃ im Verhältnis 1,8:1 bis 3:1 aufweisen. Ebenfalls besonders geeignet sind Ätzgase, die N₂, NF₃ und CHF₃ aufweisen, wobei die einzelnen Komponenten im Verhältnis N₂/(NF₃ + CHF₃) von 4:1 bis 5:1 vorliegen. Dabei kann das Verhältnis von NF₃ zu CHF₃ wie oben beschrieben sein. Günstig ist weiterhin bei einem mittleren Druck von etwa 55 mTorr (1 Torr=133Pa) und einer mittleren Anregungsleistung des Plasmas zu arbeiten, wobei die Anregungsleistung des Plasmas 1000 W nicht übersteigen sollte.

Bei diesem Ätzprozeß bilden sich Polymere, welche sich auf dem geätzten Siliziumsubstrat abscheiden. Dadurch wird ein chemischer Angriff der Ätzgase zunächst unterbunden, da die blanke Siliziumoberfläche durch die Polymere geschützt ist. Da das Trockenätzverfahren jedoch auch eine physikalische Ätzkomponente durch die gerichteten und beschleunigten Ionen der Ätzgase oder weiterer Gase aufweist, werden die Polymere wieder abgebaut. Der Abbauprozeß ist auf horizontalen Flächen, die im wesentlichen senkrecht zu den eintreffenden Ionen liegen, größer als auf vertikalen Flächen. Der Aufbauprozeß, d.h. die Rate der Polymerabscheidung ist dagegen auf allen Flächen in etwa gleich. Von horizontalen Flächen werden somit die Polymere immer wieder abgetragen, so daß ein Angriff der Ätzgase ermöglicht wird. Dagegen kommt es auf vertikalen Flächen, und damit auch auf den sich herausbildenden Seitenwänden des Grabens, zur Bildung einer zunehmend dickeren Polymerschicht. Diese führt dazu, daß eine zunehmend kleinere Fläche am Boden des Grabens unbedeckt bleibt und von den Ätzgasen abgetragen werden kann. Der Graben verjüngt sich daher zunehmend und es bilden sich geneigte Seitenwände heraus. Die Steilheit der Seitenwände läßt sich daher über das Verhältnis zwischen physikalischer und chemischer Komponente des Ätzverfahrens einstellen. Die physikalische Komponente kann beispielsweise durch einen Zusatz von Ar erhöht werden.

Die Prozeßbedingungen sollten bevorzugt so gewählt werden, daß eine verstärkte Polymerbildung enteht.

Nach diesem Tröckenätzschritt kann sich ein weiterer Trockenätzschritt anschließen, durch den die Ecken am Übergang vom Boden des Trenches zu dessen Seitenwänden verrundet werden sollen. Das hierfür vorgesehene Trockenätzen wird dabei bevorzugt mit einer Gasmischung aus NF₃, CHF₃, N₂ mit einem überwiegenden Anteil von NF₃ vorgenommen, so daß eine isotrope Prozeßführung erreicht wird.

Als besonders geeignet hat sich bei dem weiteren Trockenätzschritt ein Ätzgas ohne Verwendung von CHF₃ herausgestellt. Dieses enthält N₂ und NF₃ im Verhältnis 4:1 bis 8:1. Es ist jedoch auch möglich, CHF₃-haltige weitere Ätzgase zu verwenden. Diese enthalten dann N₂, NF₃ und CHF₃ im Verhältnis N₂/(NF₃ + CHF₃) von 4:1 bis 5:1. Auch hier kann wie oben bei einem Druck von 55 mTorr und einer Anregungsleistung von max. 1000 W gearbeitet werden.

Nachfolgend wird der geätzte Graben mit Siliziumoxid, bspw. mit TEOS, aufgefüllt. In vielen Fällen wird vor dem weiteren Strukturaufbau eine Planarisierung mittels CMP durchgeführt, bei der die auf der Oberfläche des (mono-)kristallinen Si-Substrats noch befindlichen Schichten (hier das ganzflächig aufgebrachte TEOS und vorzugsweise auch die Pad-Nitridschicht) vorzugsweise vollständig entfernt werden.

## Patentansprüche

1. Verfahren zur Herstellung einer Grabenisolation zur Isolierung zweier benachbarter Trench-Kondensatoren in einem Siliziumsubstrat, wobei die Grabenisolation zumindest einen mit einem Oxid als Isolator gefüllten Graben aufweist, mit den Schritten:
- eine Maske wird auf das Siliziumsubstrat aufgebracht, wobei das Siliziumsubstrat zwei im Siliziumsubstrat gebildete Trench-Kondensatoren mit Kragen aufweist;
- zumindest ein Ätzgas wird bereitgestellt, wobei das Ätzgas NF₃, CHF₃ und N₂ mit einem überwiegenden Anteil von CHF₃ und wenig NF₃ aufweist; und
- der Graben wird nachfolgend in dem Siliziumsubstrat und teilweise überlappend in den Trench-Kondensatoren mittels eines Trockenätzschrittes unter Verwendung des Ätzgases ausgebildet, wobei bei dem Trockenätzen Polymere entstehen, welche die Seitenwände des Grabens zumindest teilweise bedecken und somit diese zumindest teilweise vor einem Ätzangriff des verwendeten Ätzgases schützen, wobei das Siliziumsubstrat und die Kragen der Trench-Kondensatoren mit der gleichen Ätzrate geätzt werden.

2. Verfahren nach Anspruch 1
**dadurch gekennzeichnet, daß**
das Ätzgas weiterhin zumindest eine Kohlenwasserstoffverbindung enthält.

3. Verfahren nach Anspruch 2,
**dadurch gekennzeichnet, daß**
die Kohlenwasserstoffverbindung CH₄ ist.

4. Verfahren nach einem der Ansprüche 1 bis 3,
**dadurch gekennzeichnet, daß**
das Ätzgas weiterhin Ar aufweist.

5. Verfahren nach einem der Ansprüche 1 bis 4,
**dadurch gekennzeichnet, daß**
das Trockenätzen durch magnetfeldverstärktes reaktives Ionenätzen mit ICP bzw. ECR erfolgt.

6. Verfahren nach einem der Ansprüche 1 bis 5,
**dadurch gekennzeichnet, daß**
die verwendete Maske geneigte Seitenwände aufweist.

7. Verfahren nach einem der Ansprüche 1 bis 6,
**dadurch gekennzeichnet, daß**
nach der Bildung des Grabens ein weiterer Trockenätzschritt mit einem weiteren Ätzgas durchgeführt wird, durch den die Ecken am Übergang vom Boden des Grabens zu dessen Seitenwänden verrundet werden, wobei der weitere Trockenätzschritt eine isotrope Ätzkomponente aufweist.

8. Verfahren nach Anspruch 7,
**dadurch gekennzeichnet, daß**
das weitere Ätzgas NF₃, CHF₃, N₂ mit einem überwiegenden Anteil von NF3 aufweist.

## Claims

1. Method for fabricating a trench isolation for isolating two adjacent trench capacitors in a silicon substrate, the trench isolation having at least one trench filled with an oxide as insulator, having the following steps:
- a mask is applied to the silicon substrate, the silicon substrate having two trench capacitors with collars formed in the silicon substrate;
- at least one etching gas is provided, the etching gas having NF₃, CHF₃ and N₂ with a predominant proportion of CHF₃ and little NF₃; and
- the trench is subsequently formed in the silicon substrate and partly in overlapping fashion in the trench capacitors by means of a dry etching step using the etching gas, during the dry etching process polymers being produced which at least partly cover the side walls of the trench and thus protect them at least partly against an etching attack of the etching gas used, the silicon substrate and the collars of the trench capacitors being etched at the same etching rate.

2. Method according to Claim 1,
**characterized in that**
the etching gas furthermore contains at least one hydrocarbon compound.

3. Method according to Claim 2,
**characterized in that**
the hydrocarbon compound is CH₄.

4. Method according to one of Claims 1 to 3,
**characterized in that**
the etching gas furthermore has Ar.

5. Method according to one of Claims 1 to 4,
**characterized in that**
the dry etching is effected by magnetic-field-enhanced reactive ion etching with ICP or ECR.

6. Method according to one of Claims 1 to 5,
**characterized in that**
the mask used has inclined side walls.

7. Method according to one of Claims 1 to 6,
**characterized in that**
after the formation of the trench, a further dry etching step using a further etching gas is carried out, by means of which the corners at the transition between the bottom of the trench and the side walls thereof are rounded, the further dry etching step having an isotropic etching component.

8. Method according to Claim 7,
**characterized in that**
the further etching gas has NF₃, CHF₃, N₂ with a predominant proportion of NF₃.

## Revendications

1. Procédé de production d'un isolement à sillons pour isoler deux condensateurs trench voisins dans un substrat en silicium, l'isolement à sillons ayant au moins un sillon empli d'oxyde comme isolateur, comprenant les stades dans lesquels :
- on dépose un masque sur le substrat en silicium, le substrat en silicium ayant deux condensateurs trench formés dans le substrat en silicium et ayant des collets ;
- on se procure au moins un gaz d'attaque, le gaz d'attaque ayant du NF₃, du CHF₃ et du N₂ avec une proportion prépondérante de CHF₃ et peu de NF₃ ; et
- on forme le sillon ensuite dans le substrat de silicium et en partie à chevauchement dans les condensateurs trench au moyen d'un stade d'attaque à sec en utilisant le gaz d'attaque, en formant lors de l'attaque à sec des polymères qui recouvrent au moins en partie les parois latérales du sillon et le protège ainsi au moins en partie d'une attaque par le gaz d'attaque utilisé, le substrat en silicium et les collets des condensateurs Trench étant attaqués à la même vitesse d'attaque.

2. Procédé suivant la revendication 1, **caractérisé en ce que** le gaz d'attaque contient en outre au moins un composé hydrocarboné.

3. Procédé suivant la revendication 2, **caractérisé en ce que** le composé hydrocarboné est CH₄;

4. Procédé suivant l'une des revendications 1 à 3, **caractérisé en ce que** le gaz d'attaque comprend en outre de l'Ar.

5. Procédé suivant l'une des revendications 1 à 4, **caractérisé en ce que** l'on effectue l'attaque à sec par une attaque ionique réactive amplifiée par un champ magnétique par ICP ou ECR.

6. Procédé suivant l'une des revendications 1 à 5, **caractérisé en ce que** le masque utilisé a des parois latérales inclinées.

7. Procédé suivant l'une des revendications 1 à 6, **caractérisé en ce qu'**après la formation du sillon, on effectue un autre stade d'attaque à sec avec un autre gaz d'attaque, par lequel les coins à la transition du fond du sillon à ses parois latérales sont arrondis, l'autre stade d'attaque à sec ayant une composante d'attaque isotrope.

8. Procédé suivant la revendication 7, **caractérisé en ce que** l'autre gaz d'attaque comprend du NF₃, du CHF₃, du N₂ avec une proportion prépondérante de NF₃.
